# EUROPEAN PATENT APPLICATION

(11) **EP 2 519 092 A1**
(43) Date of publication of application: **31.10.2012**
(21) Application number: 10838584.0
(22) Date of filing: 28.08.2010
(51) Int. Cl.: H05K 9/00

(54) **METHOD FOR SHIELDING A PRINTED CIRCUIT BOARD AND THE PRINTED CIRCUIT BOARD THEREOF**

(30) Priority: 22.12.2009 CN 200910254377
(71) Applicant: Huawei Device Co., Ltd., Longgang District Shenzhen Guangdong 518129 (CN)
(72) Inventor: SHEN, Xiaolan, Shenzhen Guangdong 518129 (CN); LIN, Lei, Shenzhen Guangdong 518129 (CN)
(74) Representative: Isarpatent
(86) International application number: PCT/CN2010/076438
(87) International publication number: WO 2011/076021

(57) **Abstract**

The present invention provides a method for shielding a printed circuit board and a printed circuit board. The method includes: providing a substrate; manufacturing at least one layer of copper foil on the substrate; forming a first solder mask layer on the surface layer of copper foil; and forming a carbon oil layer to cover the first solder mask layer, so as to shield wirings of all copper foil layers below the carbon oil layer on the printed circuit board. The printed circuit board includes: a substrate; at least one layer of copper foil, manufactured on the substrate; a first solder mask layer, formed on the surface layer of copper foil; and a carbon oil layer, covering the first solder mask layer. To overcome a disadvantage of an increased cost resulting from shielding a printed circuit board by adding copper foil and a shield cover in the prior art, according to the embodiments of the present invention, a carbon film is utilized to implement shielding on wirings of the printed circuit board, which can guarantee a shielding effect, and meanwhile, lower the cost and simplify production.

## Description

This application claims priority to Chinese Patent Application No. 200910254377.9, filed with the Chinese Patent Office on December 22, 2009 and entitled "METHOD FOR SHIELDING PRINTED CIRCUIT BOARD AND PRINTED CIRCUIT BOARD", which is incorporated herein by reference in its entirety.

### FIELD OF THE INVENTION

The present invention relates to printed circuit board shielding, and in particular, to a method for shielding a printed circuit board and a printed circuit board manufactured by using the method.

### BACKGROUND OF THE INVENTION

There are usually wirings, such as high-speed signal lines and clock lines, on a printed circuit board (PCB board). Such wirings transmit strong interfering signals, and the signals are radiated in the form of electromagnetic waves. Therefore, a shield layer needs to be disposed on its adjacent layer, and is usually a power supply/ground plane, which provides return paths, and meanwhile, performs shielding.

In the prior art, two layers of copper foil are further added to an original PCB board. Wirings with strong radiation are laid in an inner layer, and an external layer is grounded. In this way, the original PCB board is a two-layer board, and both a first layer and a second layer have wirings; however, radiation of the wirings is too strong. In order to avoid such a defect, the PCB board is made into a four-layer board, where wirings are laid in a second layer and a third layer, and a layer of grounded copper sheet is covered on a first layer and a fourth layer at areas corresponding to the wirings, so as to shield the wirings in inner layers.

In practice, the inventor finds that the solution in the prior art has the following defects: Because the number of layers of the PCB board needs to be increased, the cost rises correspondingly; and because steps such as exposure and development are needed for manufacturing copper foil lines, a manufacturing period is long.

### SUMMARY OF THE INVENTION

Embodiments of the present invention provide a method for shielding a printed circuit board and a printed circuit board, so as to overcome defects of a high cost and a long manufacturing period for conventional printed circuit board shielding.

An embodiment of the present invention provides a method for shielding a printed circuit board, where the method includes: providing a substrate; manufacturing at least one layer of copper foil on the substrate; forming a first solder mask layer on the surface layer of copper foil; and forming a carbon oil layer to cover the first solder mask layer, so as to shield wirings of all copper foil layers below the carbon oil layer on the printed circuit board.

An embodiment of the present invention further provides a printed circuit board, including: a substrate; at least one layer of copper foil, manufactured on the substrate; a first solder mask layer, formed on the surface layer of copper foil; and a carbon oil layer, covering the first solder mask layer, so as to shield wirings of all copper foil layers below the carbon oil layer on the printed circuit board.

To overcome a disadvantage of an increased cost resulting from shielding a printed circuit board by adding copper foil and a shield cover in the prior art, according to the embodiments of the present invention, a carbon film is utilized to implement shielding on wirings of the printed circuit board, which can guarantee a shielding effect, and meanwhile, lower the cost and simplify production.

### BRIEF DESCRIPTION OF THE DRAWING

Accompanying drawings described here are provided for further understanding of the present invention, and constitute part of the application, but are not intended to limit the present invention. In the accompanying drawings:
FIG. 1 is a flowchart of a method for shielding a printed circuit board according to Embodiment 1 of the present invention;
FIG. 2 is a schematic structural diagram of a printed circuit board according to Embodiment 2 of the present invention; and
FIG. 3 is a schematic structural diagram of a printed circuit board according to Embodiment 3 of the present invention.

### DETAILED DESCRIPTION OF THE EMBODIMENTS

In order to make the objectives, technical solutions and advantages of the embodiments of the present invention clearer, the embodiments of the present invention are further described in detail below with reference to the embodiments and accompanying drawings. Here, the exemplary embodiments and the illustrations of the present invention are only intended to explain the present invention, rather than limit the present invention.

### Embodiment 1

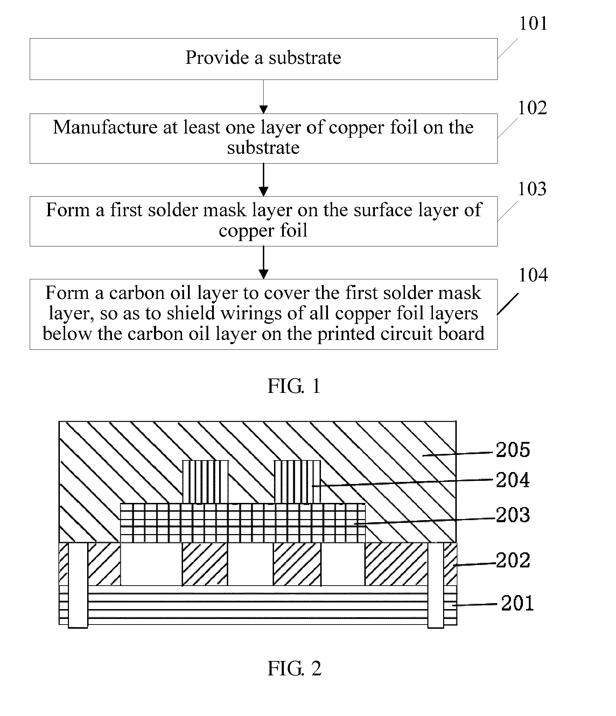

This embodiment provides a method for shielding a printed circuit board. As shown in FIG. 1, the method includes:
Step 101: Provide a substrate.
Step 102: Manufacture at least one layer of copper foil on the substrate.

In this step, the copper foil is manufactured on a surface of the substrate, and the number of layers of the copper foil may be 2, 4 or 6, and so on.

Step 103: Form a first solder mask layer on the surface layer of copper foil.

In the case of manufacturing multiple layers of copper foil, the first solder mask layer is formed on the outermost copper foil, namely, the surface layer of copper foil.

The foregoing three steps only need to be performed by using current commonly-used processes. The solder mask layer covers the surface layer of copper foil, and positions that need to be connected to electronic components are exposed. In addition, according to requirements of actual processes, positions of the surface layer of copper foil, where the positions of the surface layer of copper foil need to be grounded, may also be exposed. The solder mask layer does not cover these positions.

Step 104: Form a carbon oil layer to cover the first solder mask layer, so as to shield wirings of all copper foil layers below the carbon oil layer on the printed circuit board.

The carbon oil layer is formed by means of printing in a screen printing manner.

In this embodiment, a carbon oil layer is covered outside wirings with strong radiation on a single side of the PCB and then grounded for shielding.

Due to electrical conductivity of the carbon oil layer, as long as grounded copper foil of the PCB is exposed and contacts the carbon oil layer, a layer of carbon film may be formed above the surface layer of wirings to achieve a shielding effect. Alternatively, the carbon oil layer is connected to a large area of grounded copper foil in an inner layer of the printed circuit board through a through-hole, which can also form a shield layer to achieve a shielding effect.

Because the carbon oil layer is different from a wiring network below it, in order to prevent short circuit resulting from that the carbon oil permeates the solder mask and contacts the copper foil, an insulation layer needs to be printed between the carbon film and the copper foil for insulation. After the step of manufacturing the solder mask layer, a step may be added, that is, forming an insulation layer at a position which is on the surface of the first solder mask layer and corresponds to the surface layer of copper foil.

In this step, the insulation layer is not completely overlapped with the first solder mask layer, but instead, according to the position of the surface layer of copper foil, the insulation layer is merely disposed at a position which is on the surface of the first solder mask layer and corresponds to the surface layer of copper foil. Similarly, positions on the surface layer of copper foil, where the positions on the surface layer of copper foil need to be grounded or connected to electronic components are kept exposed, and the insulation layer does not cover these positions.

In an exemplary embodiment, a second solder mask layer is adopted as the insulation layer, and the second solder mask layer is formed by means of printing in a screen printing manner or by an exposure and developing method.

In another exemplary embodiment, a white ink layer is adopted as the insulation layer, and the white ink layer is formed by means of printing in a screen printing manner.

The insulation layer is not limited to the foregoing solder mask layer or white ink layer. For persons skilled in the art, any material capable of achieving the function of the foregoing insulation layer shall be included in the protection scope of the present invention.

When a PCB is manufactured, the surface layer of copper foil and the first layer of solder mask are manufactured first according to a conventional manufacturing process. Then, at corresponding positions on the copper foil, the second layer of solder mask is printed in a screen printing manner and cured. Finally, the carbon oil is printed in a screen printing manner and cured by baking.

According to this embodiment, the carbon oil layer is used as shield material, thereby lowering the material cost as compared with the method of using copper foil or a shield cover. In addition, there are only two steps of printing and baking for printing the carbon oil layer, so that a manufacturing process is simple, a processing period is short, and a good shielding effect is achieved.

### Embodiment 2

This embodiment provides a printed circuit board, which is manufactured by using the method according to Embodiment 1. As shown in FIG. 2, the printed circuit board includes:
a substrate 201;
at least one layer of copper foil 202, manufactured on the substrate; and
a first solder mask layer 203, formed on the surface layer of copper foil 202.

Only a layer of copper foil is taken as an example in this embodiment, to which the present invention is not limited. In actual applications, circuit boards with different numbers of layers, such as 2, 4, 6, 8, and so on of copper foil may be manufactured according to requirements. However, the first solder mask layer as well as an insulation layer and a carbon oil layer that are manufactured subsequently may only be formed on the outermost surface layer of copper foil.

A three-layer structure of the preceding printed circuit board is the same as a structure of a printed circuit board in the prior art.

A carbon oil layer 205 covers the first solder mask layer 203, so as to shield wirings of all copper foil layers below the carbon oil layer on the printed circuit board.

According to actual processing requirements, the grounded surface layer of copper foil 202 of the printed circuit board may be exposed and contacts the carbon oil layer 205, so as to form a shield layer. Alternatively, the carbon oil layer may also be connected to a large area of grounded copper foil in an inner layer of the printed circuit board through a through-hole, so as to form a shield layer to achieve a shielding effect.

Because the carbon oil layer is different from a wiring network below it, in order to prevent short circuit resulting from that the carbon oil permeates the solder mask and contacts the copper foil, an insulation layer needs to be printed between the carbon film and the copper foil for insulation. An insulation layer 204 may be added and formed at a position which is on the surface of the first solder mask layer 203 and corresponds to the surface layer of copper foil 202.

The insulation layer 204 is disposed on the surface of the first solder mask layer 203, and is only disposed at a position corresponding to the surface layer of copper foil 202 instead of covering the entire surface of the first solder mask layer 203, which aims at enhancing protection of the surface layer of copper foil 202 and preventing short circuit resulting from that the surface layer of copper foil 202 is corroded by permeating carbon oil.

In an exemplary embodiment, a second solder mask layer is adopted as the insulation layer.

In another exemplary embodiment, a white ink layer is adopted as the insulation layer.

The insulation layer is not limited to the foregoing solder mask layer or white ink layer. For persons skilled in the art, any material capable of achieving the function of the foregoing insulation layer shall be included in the protection scope of the present invention. In the printed circuit board of this embodiment, a carbon film is utilized to implement shielding on wirings of the printed circuit board, which can guarantee a shielding effect, and meanwhile, lower the cost and simplify production.

### Embodiment 3

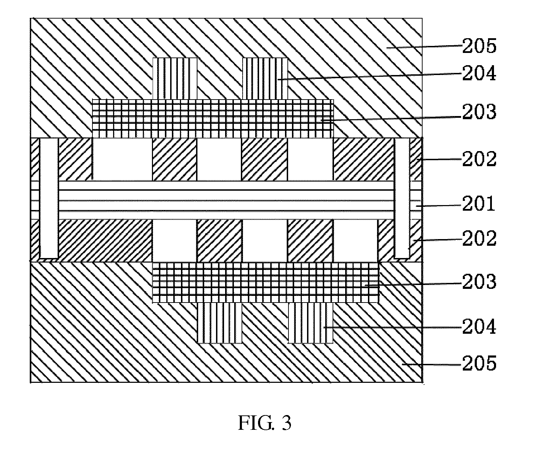

This embodiment provides a printed circuit board, which is manufactured by using the method according to Embodiment 1. As shown in FIG. 3, compared with Embodiment 2, the printed circuit board provided by this embodiment is double-sided. Double-sided wiring shielding is expanded on the basis of Embodiment 2, where a layer of carbon film is covered outside wirings with strong radiation on each of two sides of a PCB and is grounded for shielding. A structure in each layer of the PCB is the same as that in Embodiment 2, and is not repeatedly described here.

The objectives, technical solutions, and beneficial effects of the present invention are further described in detail through the foregoing specific embodiments. It should be understood that, the foregoing descriptions are merely specific embodiments of the present invention, but not intended to limit the protection scope of the present invention. Any modifications, equivalent replacements, or improvements made without departing from the spirit and principle of the present invention shall fall within the protection scope of the present invention.

## Claims

1. A method for shielding a printed circuit board, comprising:
providing a substrate;
manufacturing at least one layer of copper foil on the substrate;
forming a first solder mask layer on the surface layer of copper foil; and
forming a carbon oil layer to cover the first solder mask layer, so as to shield wirings of all copper foil layers below the carbon oil layer on the printed circuit board.

2. The method according to claim 1, wherein before the forming the carbon oil layer, the method further comprises:
forming an insulation layer at a position which is on a surface of the first solder mask layer and corresponds to the surface layer of copper foil.

3. The method according to claim 2, wherein the insulation layer is a second solder mask layer or a white ink layer.

4. The method according to claim 3, wherein the second solder mask layer is formed by means of printing in a screen printing manner or by an exposure and developing method.

5. The method according to claim 3, wherein the white ink layer is formed by means of printing in a screen printing manner.

6. The method according to claim 1, wherein the carbon oil layer is formed by means of printing in a screen printing manner.

7. The method according to claim 1, wherein grounded copper foil of the printed circuit board is exposed and contacts the carbon oil layer to form a shield layer; or
the carbon oil layer is connected to a large area of grounded copper foil in an inner layer of the printed circuit board through a through-hole to form a shield layer.

8. A printed circuit board, comprising:
a substrate;
at least one layer of copper foil, manufactured on the substrate;
a first solder mask layer, formed on the surface layer of copper foil; and
a carbon oil layer, covering the first solder mask layer and the insulation layer, so as to shield wirings of all copper foil layers below the carbon oil layer on the printed circuit board.

9. The printed circuit board according to claim 8, further comprising:
an insulation layer, formed at a position which is on a surface of the first solder mask layer and corresponds to the surface layer of copper foil.

10. The printed circuit board according to claim 8 or 9, wherein
grounded copper foil of the printed circuit board is exposed and contacts the carbon oil layer to form a shield layer; or
the carbon oil layer is connected to a large area of grounded copper foil in an inner layer of the printed circuit board through a through-hole to form a shield layer.

11. The printed circuit board according to claim 9, wherein the insulation layer is a second solder mask layer or a white ink layer.
